(19) Europäisches Patentamt
European Patent Office
Office européen des brevets

(11) **EP 3 629 367 A1**

(12) **EUROPEAN PATENT APPLICATION**
published in accordance with Art. 153(4) EPC

(43) Date of publication:
**01.04.2020 Bulletin 2020/14**

(51) Int Cl.:
*H01L 21/60* ^(2006.01)    *H01L 23/12* ^(2006.01)
*H05K 3/32* ^(2006.01)

(21) Application number: **18828625.6**

(22) Date of filing: **21.02.2018**

(86) International application number:
**PCT/JP2018/006160**

(87) International publication number:
**WO 2019/008816 (10.01.2019 Gazette 2019/02)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD TN**

(30) Priority: **06.07.2017 JP 2017132497**

(71) Applicant: **Fujikura Ltd.
Tokyo 135-8512 (JP)**

(72) Inventor: **AWAJI, Daisuke
Sakura-shi
Chiba 285-8550 (JP)**

(74) Representative: **Maiwald Patent- und
Rechtsanwaltsgesellschaft mbH
Elisenhof
Elisenstraße 3
80335 München (DE)**

(54) **SUBSTRATE MODULE, AND METHOD FOR PRODUCING SUBSTRATE MODULE**

(57)    [Problem] To electrically connect two substrates by using conductive paste while maintaining the distance between the two substrates at a predetermined distance.

[Solution] A substrate module of the present disclosure includes: a first substrate including a plurality of first pads; and a second substrate including a plurality of second pads, the first substrate and the second substrate being electrically connected. A spacer is attached to a pad of at least either of the first pads and the second pads, and one or more pairs of the first pads and the second pads not sandwiching the spacer are bonded with conductive paste in a state where the spacer is sandwiched between another pair of the first pads and the second pads.

FIG. 1A

FIG. 1B

21

20

21
41

21
41

13A(13)    31    13    11    13A(13)

10

FIG. 1C
(FIRST
EMBODIMENT)

1

21

20

21
41

21
41

13A(13)    31    13    11    13A(13)

10

## Description

Technical Field

The present invention relates to a substrate module and a method for producing the substrate module.

Background Art

Wireless communication modules that perform wireless communication by using an antenna are known. For example, Patent Literature 1 describes a wireless communication module including a wiring substrate and an RFIC chip laminated and bonded to the wiring substrate.

Citation List

Patent Literature

Patent Literature 1: JP 2014-150102A

Summary of Invention

Technical Problem

In the wireless communication module described in Patent Literature 1, a first substrate and a second substrate are bonded by using cored solder balls. Thus, in Patent Literature 1, the distance between the first substrate and the second substrate is maintained at a predetermined distance while the height of the first substrate and the second substrate is utilized for the wiring length of an antenna, which allows the antenna to have a long wiring length.

However, as described in Patent Literature 1, when two substrates are electrically connected using solder, it is necessary to melt the solder and is therefore necessary to heat the substrates. For this reason, a mounting method using solder is unsuitable for substrates having low heat resistance.

It is also known to electrically connect two substrates by using ultrasonic waves. However, ultrasonic bonding is unsuitable for substrates having low durability because a high load is applied to the substrates.

A mounting method using conductive paste for substrates having low heat resistance and low durability is known. By employing the mounting method using conductive paste, two substrates can be electrically connected at a low temperature with a low load.

However, in a case of using conductive paste, the two substrates are electrically connected by a soft pasty material, which makes it difficult to maintain the distance between the two substrates at a predetermined distance as in Patent Literature 1.

An objective of the present invention is to electrically connect two substrates by using conductive paste while maintaining the distance between the two substrates at a predetermined distance.

Solution to Problem

A main aspect of the invention to achieve the above objective is a substrate module comprising: a first substrate including a plurality of first pads; and a second substrate including a plurality of second pads, the first substrate and the second substrate being electrically connected, wherein a spacer is attached to a pad of at least either of the first pads and the second pads, and one or more pairs of the first pads and the second pads not sandwiching the spacer are bonded with conductive paste in a state where the spacer is sandwiched between another pair of the first pads and the second pads.

Other features of the invention are made clear by the following description and the drawings.

Advantageous Effects of Invention

With some embodiments of the present invention, it is possible to electrically connect two substrates by using conductive paste while maintaining the distance between the two substrates at a predetermined distance.

Brief Description of Drawings

[Fig. 1] Figs. 1A to 1C are explanatory diagrams of a wireless communication module 1 according to a first embodiment.
[Fig. 2] Figs. 2A and 2B illustrate X-ray inspection images of the wireless communication module 1 according to the first embodiment. Fig. 2C illustrates an X-ray inspection image in a case of a comparative example without spacers 41.
[Fig. 3] Figs. 3A to 3C are explanatory diagrams of a wireless communication module 1 according to a second embodiment.
[Fig. 4] Figs. 4A to 4C are explanatory diagrams of a wireless communication module 1 according to a third embodiment.
[Fig. 5] Figs. 5A and 5B are explanatory diagrams of the comparative example.

Description of Embodiments

At least the following matters are made clear from the following description and the drawings.

A substrate module will become clear comprising: a first substrate including a plurality of first pads; and a second substrate including a plurality of second pads, the first substrate and the second substrate being electrically connected, wherein a spacer is attached to a pad of at least either of the first pads and the second pads, and one or more pairs of the first pads and the second pads not sandwiching the spacer are bonded with conductive paste in a state where the spacer is sandwiched between another pair of the first pads and the second pads. According to such a substrate module, it is possible to electrically connect the two substrates by using the conductive paste while maintaining the distance between the two substrates at a predetermined distance.

A plurality of the spacers are preferably attached to two pads of at least either of the first pads and the second pads. In this way, the positional relationship between the two substrates can be examined.

The pad to which the spacer is attached is preferably a ground pad. This eliminates any influence on operations.

The spacer is preferably constituted to be detectable in X-ray inspection. This allows the use of the spacer in X-ray inspection.

The first pads are preferably constituted to be detectable in X-ray inspection; and the spacer is preferably attached to a pad of the second pads. In this way, the positional relationship between the first substrate and the second substrate can be examined on the basis of the positional relationship between an image indicating the first pad and an image indicating the spacer in an X-ray inspection image.

A pad of the first pads sandwiching the spacer is preferably larger than the spacer when viewed from an examination direction in the X-ray inspection. This facilitates an X-ray inspection.

The spacers are preferably attached to a pad of the first pads and a pad of the second pads; an end portion of one of the spacers attached to the pad of the first pads and an end portion of another of the spacers attached to the pad of the second pads are preferably in contact with each other, the end portion of one of the spacers attached to the pad of the first pads being opposite to the first pads, the end portion of another of the spacers attached to the pad of the second pads being opposite to the second pads. In this way, it is possible to maintain the two substrates spaced at a large distance.

The spacer is preferably formed by stacking a metal layer. In such a case, a structure in which the spacer is attached to each of the first pad and the second pad is particularly advantageous.

The first substrate is preferably a wiring substrate including an antenna; and the second substrate is preferably a semiconductor chip for controlling the antenna. In this way, it is possible to suppress deterioration of the characteristics of the semiconductor chip due to the influence of the wiring substrate when the semiconductor chip operates at a high frequency.

A method for producing a substrate module, the method preferably comprising: preparing a first substrate including a plurality of first pads and a second substrate including a plurality of second pads; and electrically connecting the first substrate and the second substrate, wherein preferably a spacer is attached to a pad of at least either of the first pads and the second pads, and

one or more pairs of the first pads and the second pads not sandwiching the spacer are bonded with conductive paste in a state where the spacer is sandwiched between another pair of the first pads and the second pads. With such a method for producing a substrate module, it is possible to electrically connect the two substrates by using conductive paste while maintaining the distance between the two substrates at a predetermined distance.

{First Embodiment}

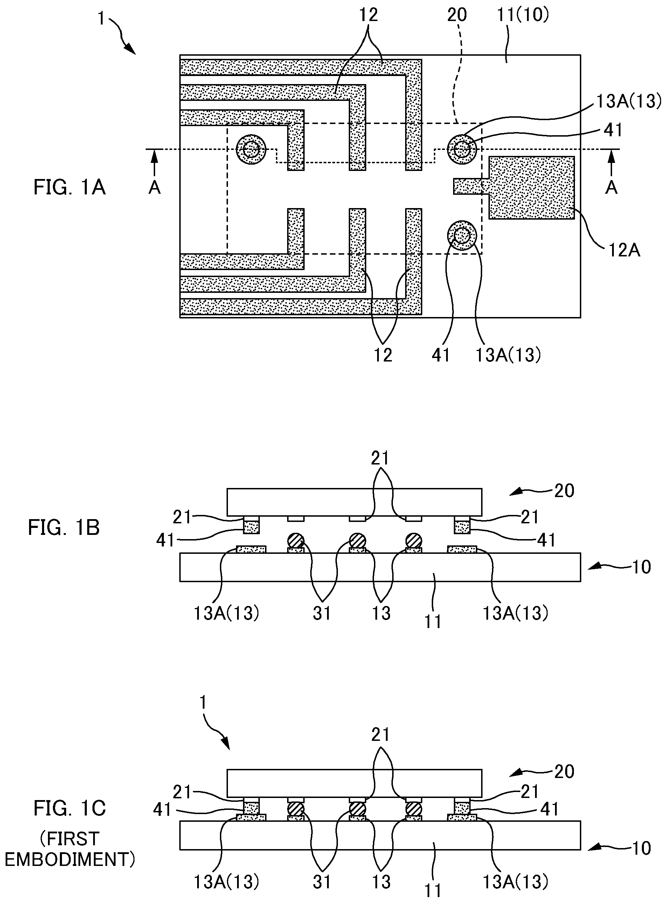

Figs. 1A to 1C are explanatory diagrams of a wireless communication module 1 according to a first embodiment. Fig. 1A is a top view of the wireless communication module 1 of the first embodiment, and here, a semiconductor chip 20 mounted on an antenna substrate 10 is illustrated transparently. Fig. 1B is an explanatory diagram of a state at the time of producing the wireless communication module 1 according to the first embodiment. Fig. 1C is a diagram illustrating a cross section taken along A-A in Fig. 1A. Note that, in the following description, the direction perpendicular to a substrate surface of the antenna substrate 10 is referred to as the "up-down direction", the side of the semiconductor chip 20 as viewed from the antenna substrate 10 is referred to as "up", and the opposite side is referred to as "down", in some cases.

The wireless communication module 1 of the first embodiment is a module that performs wireless communication in a millimeter wave band (30 to 300 GHz). The wireless communication module 1 includes the antenna substrate 10 and the semiconductor chip 20. The semiconductor chip 20 is flip-chip mounted on the antenna substrate 10. In the present embodiment, conductive paste 31 is used to electrically connect the antenna substrate 10 and the semiconductor chip 20.

The antenna substrate 10 is a substrate (first substrate) on which the semiconductor chip 20 is mounted. The antenna substrate 10 includes a substrate body 11, a wiring pattern 12, and substrate-side pads 13.

The wiring pattern 12 and the substrate-side pads 13 are formed on an upper surface of the substrate body 11. In addition, on the upper surface of the substrate body 11, a region where the semiconductor chip 20 is mounted (a chip mounting region: a region indicated by dotted lines in Fig. 1A) is provided. Note that a material having a small dielectric loss tangent is desirably used for the substrate body 11. This is because, in a case of the wireless communication module 1 that operates at a high frequency in the millimeter wave band (30 to 300 GHz), the greater the frequency is, the greater the conductor loss and the dielectric loss become. Hence it is necessary to design the wireless communication module 1 in such a manner as to suppress conductor loss and dielectric loss.

The wiring pattern 12 is a pattern constituting wiring and is formed on the substrate body 11. Here, the wiring pattern 12 is formed on the upper surface of the substrate body 11, but the wiring pattern 12 may be formed inside the substrate body 11 or on a lower surface of the substrate body 11. The wiring pattern 12 includes a signal line for transmitting a signal, ground wiring serving a ground potential, and the like. The wiring pattern 12 of the present embodiment also includes an antenna pattern 12A.

The substrate-side pads 13 are pads for electrically connecting with the semiconductor chip 20. The substrate-side pads 13 are mainly provided on the wiring pattern 12 and are provided inside the chip mounting region on the upper surface of the substrate body 11.

The wiring pattern 12 and the substrate-side pads 13 of the present embodiment are made of X-ray absorbent materials (materials that have high X-ray absorption). Specifically, the wiring pattern 12 and the substrate-side pads 13 are made of, for example, copper, copper alloy, or the like. The wiring pattern 12 may be formed by applying gold plating to copper wiring. The wiring pattern 12 and the substrate-side pads 13 of the present embodiment are detectable by X-ray inspection.

The semiconductor chip 20 is a substrate (second substrate) mounted on the antenna substrate 10 (first substrate). In the present embodiment, the semiconductor chip 20 is a so-called RFIC chip. Since the semiconductor chip 20 that operates at a high frequency, such as an RFIC chip, may possibly deteriorate in characteristics due to the influence of the wiring and the like on the antenna substrate 10, a space is provided between the antenna substrate 10 and the semiconductor chip 20 in the present embodiment. In this manner, this structure maintains the distance between the antenna substrate 10 and the semiconductor chip 20 at a predetermined distance, and thus suppresses transmission loss due to dielectric characteristics.

A plurality of chip-side pads 21 are provided on the lower surface of the semiconductor chip 20. The chip-side pads 21 are pads (connecting terminals) provided on the semiconductor chip 20 and for electrically connecting with the substrate-side pads 13. In the present embodiment, the chip-side pads 21 not provided with the spacers 41 and the corresponding substrate-side pads 13 are bonded with the conductive paste 31.

Note that the chip-side pads 21 of the present embodiment are constituted to absorb less X-rays than the substrate-side pads 13 and are hence constituted to be difficult to detect by X-ray inspection as compared with the substrate-side pads 13. The chip-side pads 21 are made, for example, of aluminum or the like.

The conductive paste 31 is a pasty conductive member that electrically connects the antenna substrate 10 and the semiconductor chip 20 with each other. The conductive paste 31 before curing is a pasty member and is hence a relatively soft member. However, the conductive paste 31 also functions as a bonding member that mechanically bonds the antenna substrate 10 and the semiconductor chip 20 by curing. The conductive paste 31 is made, for example, of a curable resin (conductive adhesive) in which conductive particles are dispersed. Since the conductive paste 31 is constituted with conductive metallic particles being dispersed, the conductive paste 31 is a member that is difficult to detect by X-ray inspection compared with the substrate-side pads 13.

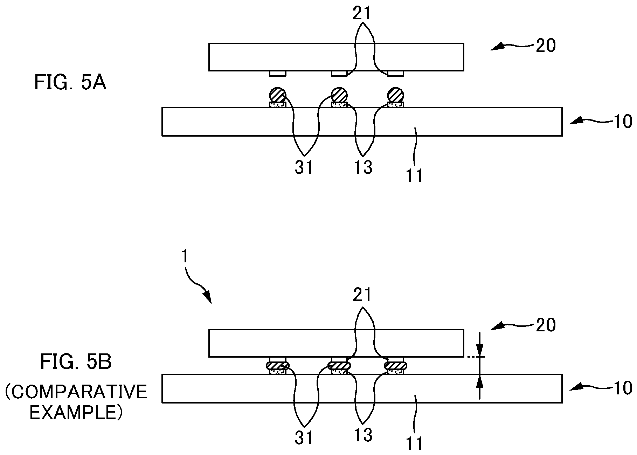

Figs. 5A and 5B are explanatory diagrams of a comparative example. Fig. 5A is an explanatory diagram before an antenna substrate 10 and a semiconductor chip 20 are bonded. Fig. 5B is an explanatory diagram after the antenna substrate 10 and the semiconductor chip 20 are bonded and is an explanatory diagram of a structure of a wireless communication module 1 according to the comparative embodiment.

In the comparative example, substrate-side pads 13 of the antenna substrate 10 and chip-side pads 21 of the semiconductor chip 20 are bonded with conductive paste 31 without sandwiching any spacers 41 between the substrate-side pads 13 and the chip-side pads 21. By employing such a bonding method using the conductive paste 31, it is possible to electrically connect two substrates (the antenna substrate 10 and the semiconductor chip 20) at a low temperature with a low load as compared with solder bonding or ultrasonic bonding. However, in a case that the conductive paste 31 is used, the two substrates (the antenna substrate 10 and the semiconductor chip 20) are electrically connected with a soft pasty material, and this consequently makes it difficult to maintain the distance between the two substrates (the distance indicated by the arrows in the drawing) at the predetermined distance. Moreover, it is difficult to control the load applied between the two substrates at the time of bonding for maintaining the distance between the two substrates (the distance indicated by the arrows in the drawing) at the predetermined distance.

Incidentally, as has already been described, although the antenna substrate 10 is made of the material having a low dielectric loss tangent in order to suppress loss during high-frequency operation, the characteristics of the semiconductor chip 20 (RFIC) may still possibly be deteriorated due to the influence of the wiring on the antenna substrate 10 during high-frequency operation. In view of this, it is desirable to maintain the distance between the antenna substrate 10 and the semiconductor chip 20 at the predetermined distance so that the antenna substrate 10 and the semiconductor chip 20 do not come too close to each other, and in the present embodiment, the distance between the antenna substrate 10 and the semiconductor chip 20 is assumed to be 50 $\mu$m or greater. However, in the bonding method described in the comparative example, since the conductive paste 31 is soft, it is extremely difficult to set a load (load applied between the two substrates) such that the distance between the antenna substrate 10 and the semiconductor chip 20 is 50 $\mu$m.

In view of this, in the present embodiment, the spacers 41 (refer to Figs. 1B and 1C) are provided in order to facilitate maintaining the distance between the two substrates at the predetermined distance at the time of bonding the two substrates (the antenna substrate 10 and the semiconductor chip 20).

The spacers 41 are members that define the distance between the two substrates to the predetermined distance. In the present embodiment, the spacers 41 are provided by being sandwiched between the substrate-side pads 13A of the antenna substrate 10 and the chip-side pads 21 of the semiconductor chip 20, to thereby define the distance between the antenna substrate 10 and the semiconductor chip 20 to the predetermined distance.

The spacers 41 are formed on the chip-side pads 21. By providing the spacers 41 on the chip-side pads 21, the spacers 41 can be formed as bumps (spacer bumps) (the spacers 41 can be formed in the same manner as bumps). For example, the spacers 41 are formed as copper pillars or gold stud bumps. In a case that the spacers 41 are copper pillars, a manufacturer of the semiconductor chip 20 produces the semiconductor chip 20 on which the copper pillars are formed in advance on the chip-side pads 21, and a module manufacturer who purchased the semiconductor chip 20 with the spacers 41 being already formed produces the wireless communication module 1 as illustrated in Fig. 1B. In a case that the spacers 41 are gold stud bumps, in contrast, the module manufacturer can attach the spacers 41 to the chip-side pads 21 of the semiconductor chip 20 later.

Since the spacers 41 are provided on the chip-side pads 21, lower ends of the spacers 41 (end portions of the spacers 41, the end portions being opposite to the chip-side pads 21) protrude below the chip-side pads 21, on the lower surface of the semiconductor chip 20 as illustrated in Fig. 1B. When the antenna substrate 10 and the semiconductor chip 20 are bonded, the semiconductor chip 20 is brought close to the antenna substrate 10 in a state where the lower ends of the spacers 41 are directed toward the antenna substrate 10, to cause the lower ends of the spacers 41 to abut against (contact) the substrate-side pads 13A of the antenna substrate 10, as illustrated in Fig. 1B. Note that, as illustrated in Fig. 1B, the conductive paste 31 is applied in advance to the substrate-side pads 13 to be electrically connected to the chip-side pads 21.

When the lower ends of the spacers 41 abut against the substrate-side pads 13A of the antenna substrate 10, the conductive paste 31 is arranged between the substrate-side pads 13 of the antenna substrate 10 and the chip-side pads 21 of the semiconductor chip 20, and also the spacers 41 are sandwiched between the two substrates, as illustrated in Fig. 1C. As illustrated in Fig. 1C, the load applied between the antenna substrate 10 and the semiconductor chip 20 changes when the lower ends of the spacers 41 come to contact the antenna substrate 10 (the substrate-side pads 13A of the antenna substrate 10). Hence, by stopping the approach between the antenna substrate 10 and the semiconductor chip 20 at the stage when the change of the load is detected, the distance between the two substrates results in a distance (predetermined distance) corresponding to the height (thickness) of the spacers 41. Note that the conductive paste 31 is cured after the lower ends of the spacers 41 abut against the substrate-side pads 13A of the antenna substrate 10, whereby the substrate-side pads 13 and the chip-side pads 21 are bonded with the conductive paste 31. According to the present embodiment, the substrate-side pads 13 and the chip-side pads 21 not sandwiching the spacers 41 are bonded with the conductive paste 31 in a state where the spacers 41 are sandwiched between other pads of the two substrates as illustrated in Fig. 1C, which prevents the soft pasty conductive paste 31 from being crushed and makes it possible to maintain the distance between the two substrates at the predetermined distance.

In the present embodiment, the spacers 41 are provided on the three chip-side pads 21 of the semiconductor chip 20. In this way, it is desirable that three spacers 41 be provided and that, on a straight line connecting two of the spacers 41, the other spacer 41 be not arranged. With this, it is possible to stabilize the posture of the semiconductor chip 20 with respect to the antenna substrate 10 at the time of bonding and to facilitate maintaining the distance between the two substrates (the antenna substrate 10 and the semiconductor chip 20) at the predetermined distance. However, the number of spacers 41 is not limited to three and may be four or more. Even in a case that four or more spacers 41 are provided, it is desirable that, on a straight line connecting two of the spacers 41, the other spacers 41 be not arranged.

Note that the number of spacers 41 may be less than three (one or two). Even if the number of spacers 41 is one, the load applied between the antenna substrate 10 and the semiconductor chip 20 changes when the lower end of the spacer 41 comes into contact with the corresponding substrate-side pad 13A of the antenna substrate 10, whereby detection of the contact is possible. In a case that the number of spacers 41 is less than three, by bringing the spacer (s) 41 into contact with the antenna substrate 10 while maintaining the semiconductor chip 20 to be parallel with the antenna substrate 10, the distance between the two substrates (the antenna substrate 10 and the semiconductor chip 20) can be maintained at the predetermined distance. With at least two spacers 41, it is possible to determine whether the positional relationship between the antenna substrate 10 and the semiconductor chip 20 at the time of X-ray inspection is normal or abnormal.

In a case that three or more spacers 41 are provided, pads (the substrate-side pads 13 and the chip-side pads 21) to be electrically connected with the conductive paste 31 are desirably arranged in a region surrounded by the three or more spacers 41. In other words, the three or more spacers 41 are desirably arranged on an outer side of the lower surface of the semiconductor chip 20 if possible. This facilitates stabilizing the posture of the semiconductor chip 20 with respect to the antenna substrate 10 at the time of bonding.

A number of chip-side pads 21 are provided on the lower surface of the semiconductor chip 20, and a plurality of the chip-side pads 21 are constituted as ground pads. In the present embodiment, the spacers 41 are provided on such ground chip-side pads 21. Hence, even when the spacers 41 are provided on the chip-side pads 21, this does not affect operations of the semiconductor chip 20.

The spacers 41 contact the substrate-side pads 13A provided on the upper surface of the substrate body 11. In this way, the substrate-side pads 13 and the chip-side pads 21 can be spaced from each other for the height (thickness) of the spacers 41, which makes it possible to maintain the distance between the antenna substrate 10 and the semiconductor chip 20 at the predetermined distance. The substrate-side pads 13A which the spacers 41 contact may be connected to ground wiring or may be independent of the wiring pattern 12.

In the present embodiment, the substrate-side pads 13A (inspection pads 13A) which the spacers 41 contact are also used in X-ray inspection. Accordingly, the substrate-side pads 13A (inspection pads 13A) which the spacers 41 contact, as the other substrate-side pads 13, are made of an X-ray absorbent material (a material that has high X-ray absorption), and are hence detectable in X-ray inspection. In this way, the substrate-side pads 13A which the spacers 41 contact can function as alignment marks.

In the present embodiment, the substrate-side pads 13A (inspection pads 13A) which the spacers 41 contact are formed to be larger than the spacers 41 when viewed in an examination direction in X-ray inspection (direction perpendicular to the antenna substrate 10) to facilitate X-ray inspection. Specifically, in the present embodiment, the diameter of the inspection pads 13A is greater than the diameter of the spacers 41.

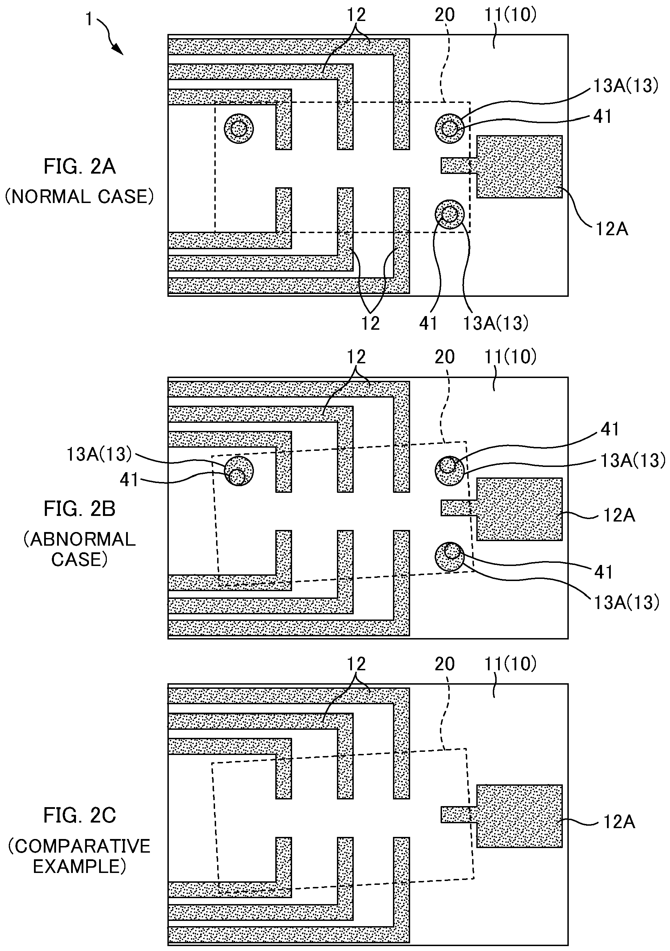

Figs. 2A and 2B illustrate images (X-ray inspection images) at the time when the wireless communication module 1 of the first embodiment is examined in X-ray inspection. Fig. 2A is an X-ray inspection image in a case that the positional relationship between the antenna substrate 10 and the semiconductor chip 20 is normal. Fig. 2B is an X-ray inspection image in a case that the positional relationship between the antenna substrate 10 and the semiconductor chip 20 is abnormal. In Figs. 2A and 2B, members detected in X-ray inspection are shaded by hatching. The members detected in X-ray inspection include the wiring pattern 12 (also including the antenna pattern 12A), the substrate-side pads 13 (also including the inspection pads 13A), and the spacers 41. Note that the chip-side pads 21 and the conductive paste 31, which have low X-ray absorption, do not appear in an X-ray inspection image.

In a case that the positional relationship between the antenna substrate 10 and the semiconductor chip 20 is normal (case that the semiconductor chip 20 is normally mounted on the chip mounting region of the antenna substrate 10), the lower ends of the spacers 41 are in a state of abutting against central positions of the inspection pads 13A (refer to Fig. 1C). Hence, by examining the positional relationship between circular images indicating the spacers 41 and circular images indicating the inspection pads 13A in an X-ray inspection image, it is possible to determine whether the positional relationship between the antenna substrate 10 and the semiconductor chip 20 is normal or abnormal. In the present embodiment, since the diameter of the inspection pads 13A is greater than the diameter of the spacers 41, it is possible to determine that the positional relationship between the antenna substrate 10 and the semiconductor chip 20 is normal when the smaller-circular images indicating the spacers 41 and the greater-circular images indicating the inspection pads 13A are concentrically arranged (refer to Fig. 2A). In contrast, it is possible to determine that the positional relationship between the antenna substrate 10 and the semiconductor chip 20 is abnormal when the small-circular images indicating the spacers 41 are deviated from the central positions of the great-circular images indicating the inspection pads 13A. In this way, with the inspection pads 13A having a greater diameter than the diameter of the spacers 41, X-ray inspection can be facilitated. Note that even if the spacers 41 are larger than the inspection pads 13A, portions where the images indicating the spacers 41 and the images indicating the inspection pads overlap each other appear darker, which enables X-ray inspection. Even if the spacers 41 and the inspection pads 13A have similar sizes, it is possible to determine whether the positional relationship between the antenna substrate 10 and the semiconductor chip 20 is normal or abnormal, by examining the positional relationship between the images indicating the spacers 41 and the images indicating the inspection pads 13A.

Fig. 2C illustrates an X-ray inspection image of the comparative example without the spacers 41. In a case that no spacers 41 are attached to the semiconductor chip 20 (refer to Fig. 5B), the position of the semiconductor chip 20 is not detectable on the basis of an X-ray inspection image as illustrated in Fig. 2C. In contrast to this, in the present embodiment, the spacers 41 are provided on the chip-side pads 21 of the semiconductor chip 20, whereby an effect is achieved that the positional relationship between the antenna substrate 10 and the semiconductor chip 20 is detectable on the basis of an X-ray inspection image as illustrated in Figs. 2A and 2B. Note that this effect is an effect in different aspect (remarkable effect) in comparison with an effect as the spacers 41 for defining the distance between the two substrates at the predetermined distance.

As illustrated in Figs. 2A and 2B, the spacers 41 are constituted to be detectable in X-ray inspection in the present embodiment. Hence, the spacers 41 are constituted so as to be easily detected in X-ray inspection compared with the chip-side pads 21. Specifically, the spacers 41 are constituted so as to have a greater intensity I of the following equation than that of the chip-side pads 21.

[Math 1]

$$I = I_0 \exp\left(-\mu\, d\right) = I_0 \exp\left(-\frac{\mu}{\rho}\, \omega\right)$$

In the above equation, $I_0$ denotes an intensity of incident rays (gamma rays). I denotes an intensity after passing through an absorption layer. d denotes the thickness of the absorption layer. $\mu$ denotes an absorption coefficient. $\rho$ denotes a density. $\omega$ denotes an absorption coefficient at the time when the thickness d of the absorption layer is expressed by mass per area. The spacers 41 are desirably made of a material having a higher mass absorption coefficient ($\mu/\rho$) than that of the chip-side pads 21. Here, as described above, the spacers 41 are made of copper, gold, or the like, for example. The spacers 41 may be formed thicker than the chip-side pads 21.

{Second Embodiment}

In the first embodiment described above, the spacers 41 are attached to the chip-side pads 21. However, the spacers 41 may be attached to at least either of the substrate-side pads 13 and the chip-side pads 21. In a second embodiment, the spacers 41 are attached to both the substrate-side pads 13 and the chip-side pads 21.

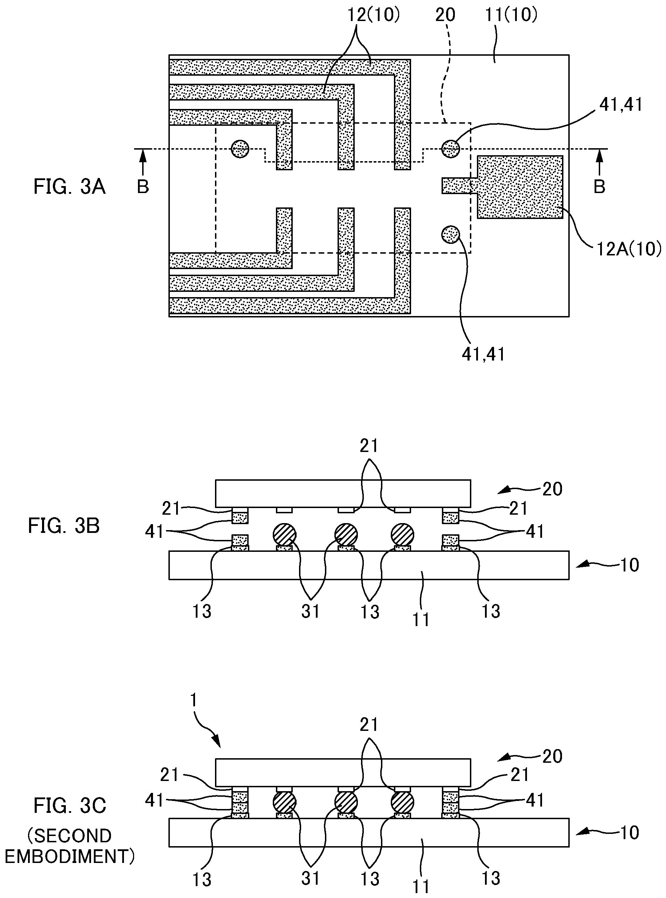

Figs. 3A to 3C are explanatory diagrams of a wireless communication module 1 according to the second embodiment. Fig. 3A is a top view of the wireless communication module 1 according to the second embodiment, and here, the semiconductor chip 20 mounted on the antenna substrate 10 is illustrated transparently. In other words, Fig. 3A illustrates an image (X-ray inspection image) at the time when the wireless communication module 1 is examined in X-ray inspection. In Fig. 3A, members detected in the X-ray inspection are shaded by hatching. Fig. 3B is an explanatory diagram of a state of producing the wireless communication module 1 according to the second embodiment. Fig. 3C is a diagram illustrating a cross section taken along B-B in Fig. 3A.

As illustrated in Fig. 3B, in the second embodiment, the spacers 41 are attached to both of the pads, i.e., the substrate-side pads 13 and the chip-side pads 21. Hence, as illustrated in Fig. 3B, the upper ends of the spacers 41 attached to the substrate-side pads 13 (the end portions of the spacers 41, the end portions being opposite to the substrate-side pads 13) protrude above the substrate-side pads 13 on the upper surface of the antenna substrate 10, and also the lower ends of the spacers 41 attached to the chip-side pads 21 (the end portions of the spacers 41, the end portions being opposite to the chip-side pads 21) protrude below the chip-side pads 21 on the lower surface of the semiconductor chip 20. At the time of bonding the antenna substrate 10 and the semiconductor chip 20, the upper ends of the spacers 41 attached to the substrate-side pads 13 and the lower ends of the spacers 41 attached to the chip-side pads 21 come to abut against (contact) each other as illustrated in Fig. 3B. Note that, as illustrated in Fig. 3B, the conductive paste 31 is applied in advance to the substrate-side pads 13 to be electrically connected to the chip-side pads 21.

When the spacers 41 abut against each other, the conductive paste 31 is arranged between the substrate-side pads 13 of the antenna substrate 10 and the chip-side pads 21 of the semiconductor chip 20, and also the spacers 41 are sandwiched between the pads of the two substrates, as illustrated in Fig. 3C. Also in the second embodiment, the distance between the two substrates is defined to a predetermined distance with the spacers 41, which prevents the soft pasty conductive paste 31 from being crushed. After the lower ends of the spacers 41 attached to the chip-side pads 21 of the semiconductor chip 20 abut against the upper ends of the spacers 41 attached to the substrate-side pads 13 of the antenna substrate 10, the conductive paste 31 is cured, whereby the substrate-side pads 13 and the chip-side pads 21 not sandwiching the spacers 41 are bonded with the conductive paste 31.

Also in the second embodiment, the substrate-side pads 13 and the chip-side pads 21 not sandwiching the spacers 41 are bonded with the conductive paste 31 in a state where the spacers 41 are sandwiched between the substrate-side pads 13A of the antenna substrate 10 and the chip-side pads 21 of the semiconductor chip 20, as illustrated in Fig. 3C. With this, it is possible to prevent the soft pasty conductive paste 31 from being crushed, and to maintain the distance between the two substrates (the antenna substrate 10 and the semiconductor chip 20) at the predetermined distance.

As in the second embodiment, the spacers 41 are attached to both pads, i.e., the substrate-side pads 13 and the chip-side pads 21, which makes it possible to maintain the distance between the two substrates (the antenna substrate 10 and the semiconductor chip 20) spaced at a large distance. For example, in a case that the substrate-side pads 13 and the chip-side pads 21 are miniaturized as the antenna substrate 10 and the semiconductor chip 20 are miniaturized, the height (thickness) of the spacer 41 that can be attached to the pads may be limited. Hence, in a case that it is desired to maintain the two substrates (the antenna substrate 10 and the semiconductor chip 20) spaced at a large distance under such a situation, it is desirable that the spacers 41 be attached to both the substrate-side pads 13 and the chip-side pads 21. Specifically, in a case that the spacers 41 are formed by stacking a metal layer on the pads such as copper pillars, the height of the spacers 41 depends on the area of the pads. Hence, if the areas of the substrate-side pads 13 and the chip-side pads 21 are small, the spacers 41 that can be stacked on the pads result in being low in height, and therefore, it is preferable, in such a situation, that the spacers 41 be attached to both the substrate-side pads 13 and the chip-side pads 21.

Also in the second embodiment, the spacers 41 are constituted to be detectable in X-ray inspection. Hence, by examining, in an X-ray inspection image, the positional relationship between circular images indicating the spacers 41 of the substrate-side pads 13 and circular images indicating the spacers 41 of the chip-side pads 21, it is possible to determine whether the positional relationship between the antenna substrate 10 and the semiconductor chip 20 is normal or abnormal. For example, in the X-ray inspection image illustrated in Fig. 3A, it is possible to determine that the positional relation between the antenna substrate 10 and the semiconductor chip 20 is normal on the basis of the fact that the circular images indicating the spacers 41 of the substrate-side pads 13 and the circular images indicating the spacers 41 of the chip-side pads 21 overlap with each other.

{Third Embodiment}

As has already been described, the spacers 41 may be attached to at least either of the substrate-side pads 13 and the chip-side pads 21. In a third embodiment, the spacers 41 are not attached to the chip-side pads 21, but are attached to the substrate-side pads 13.

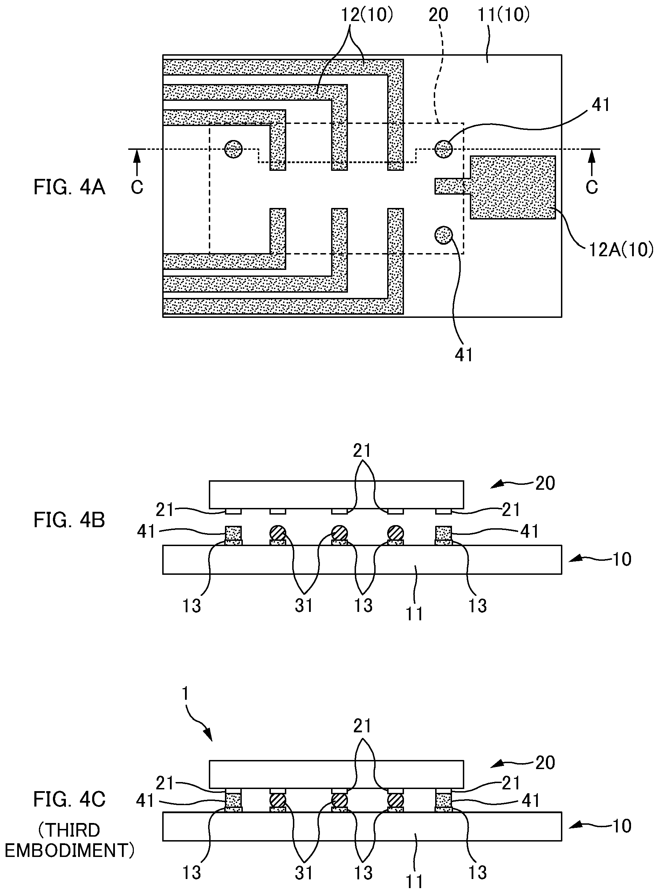

Figs. 4A to 4C are explanatory diagrams of a wireless communication module 1 according to the third embodiment. Fig. 4A is a top view of the wireless communication module 1 according to the third embodiment, and here, the semiconductor chip 20 mounted on the antenna substrate 10 is illustrated transparently. Fig. 4B is an explanatory diagram of a state of manufacturing the wireless communication module 1 according to the third embodiment. Fig. 4C is a diagram illustrating a cross section taken along C-C in Fig. 4A.

As illustrated in Fig. 4B, the spacers 41 are attached to the substrate-side pads 13 in the third embodiment. Hence, as illustrated in Fig. 4B, the upper ends of the spacers 41 protrude above the substrate-side pads 13 on the upper surface of the antenna substrate 10. At the time of bonding the antenna substrate 10 and the semiconductor chip 20, the upper ends of the spacers 41 and the chip-side pads 21 abut against each other as illustrated in Fig. 4B. Note that as illustrated in Fig. 4B, the conductive paste 31 is applied in advance to the substrate-side pads 13 to be electrically connected to the chip-side pads 21.

When the upper ends of the spacers 41 abut against the chip-side pads 21, the conductive paste 31 is arranged between the substrate-side pads 13 of the antenna substrate 10 and the chip-side pads 21 of the semiconductor chip 20, and the spacers 41 are sandwiched between the pads of the two substrates, as illustrated in Fig. 4C. Also in the third embodiment, the distance between the two substrates is defined to the predetermined distance by the spacers 41, which prevents the soft pasty conductive paste 31 from being crushed. After the upper ends of the spacers 41 abut against the chip-side pads 21 of the semiconductor chip 20, the conductive paste 31 is cured, whereby the substrate-side pads 13 and the chip-side pads 21 not sandwiching the spacers are bonded with the conductive paste 31.

In the third embodiment, the semiconductor chip 20 is not provided with any member (e.g., the spacers 41) that can be detected during X-ray inspection. Hence, in the structure of the third embodiment, it is difficult to determine the positional relation between the antenna substrate 10 and the semiconductor chip 20 on the basis of X-ray inspection images (refer to Fig. 4A). However, also in the third embodiment, the substrate-side pads 13 and the chip-side pads 21 not sandwiching the spacers 41 are bonded with the conductive paste 31 in a state where the spacers 41 are sandwiched between the substrate-side pads 13A of the antenna substrate 10 and the chip-side pads 21 of the semiconductor chip 20, as illustrated in Fig. 4C. Hence, also in the third embodiment, it is possible to prevent the soft pasty conductive paste 31 from being crushed and to maintain the distance between the two substrates (the antenna substrate 10 and the semiconductor chip 20) at a predetermined distance.

{Other Embodiments}

In each of the above-described embodiments, the wireless communication module including the antenna substrate 10 (first substrate) including an antenna and the semiconductor chip 20 (second substrate) controlling the antenna has been described. However, a substrate module including two substrates is not limited to a wireless communication module including an antenna.

Specifically, the techniques of the above-described embodiments are also applicable to a substrate module that includes a first substrate including a plurality of first pads and a second substrate including a plurality of second pads and electrically connecting the first substrate and the second substrate with each other. In this case, if the spacer (s) 41 is attached to at least either of the first pads and the second pads, and the first pads and the second pads not sandwiching the spacer(s) 41 are bonded by the conductive paste 31 in a state where the spacer(s) 41 is sandwiched between the first pad(s) and the second pad(s), it is possible to prevent the soft pasty conductive paste 31 from being crushed and to maintain the distance between the two substrates at a predetermined distance.

In a case of the wireless communication module 1 operating at a high frequency of a millimeter wave band (30 to 300 GHz) as in the above-described embodiments, however, the characteristics of the semiconductor chip 20 (RFIC) operating at a high frequency may possibly be deteriorated due to the influence of the wiring on the antenna substrate 10, and hence, it is desirable to maintain the semiconductor chip 20 at the predetermined distance from the antenna substrate 10. In view of this, the structure in which the first pads and the second pads are bonded with the conductive paste 31 in a state where the spacers 41 are sandwiched between the first substrate and the second substrate is desirably used in the wireless communication module 1 in particular.

{Others}

The foregoing embodiments are for facilitating the understanding of the present invention, and are not to be construed as limiting the present invention. The present invention may be modified and/or improved without departing from the gist thereof, and it goes without saying that the present invention encompasses any equivalents thereof.

Reference Signs List

| 1: | Wireless communication module; |
|---|---|
| 10: | Antenna substrate (first substrate); |
| 11: | Substrate body; |
| 12: | Wiring pattern; |
| 12A: | Antenna pattern; |
| 13: | Substrate-side pad (first pad); |
| 13A: | Inspection pad; |
| 20: | Semiconductor chip (second substrate); |
| 21: | Chip-side pad (second pad); |
| 31: | Conductive paste; |
| 41: | Spacer. |

**Claims**

1. A substrate module comprising:

   a first substrate including a plurality of first pads; and
   a second substrate including a plurality of second pads, the first substrate and the second substrate being electrically connected, wherein
   a spacer is attached to a pad of at least either of the first pads and the second pads, and
   one or more pairs of the first pads and the second pads not sandwiching the spacer are bonded with conductive paste in a state where the spacer is sandwiched between another pair of the first pads and the second pads.

2. The substrate module according to claim 1, wherein a plurality of the spacers are attached to two pads of at least either of the first pads and the second pads.

3. The substrate module according to claim 1 or 2, wherein the pad to which the spacer is attached is a ground pad.

4. The substrate module according to any one of claims 1 to 3, wherein the spacer is constituted to be detectable in X-ray inspection.

5. The substrate module according to claim 4, wherein:

   the first pads are constituted to be detectable in X-ray inspection; and
   the spacer is attached to a pad of the second pads.

6. The substrate module according to claim 5, wherein a pad of the first pads sandwiching the spacer is larger than the spacer when viewed from an examination direction in the X-ray inspection.

7. The substrate module according to any one of claims 1 to 6, wherein:

   the spacers are attached to a pad of the first pads and a pad of the second pads;
   an end portion of one of the spacers attached to the pad of the first pads and an end portion of another of the spacers attached to the pad of the second pads are in contact with each other, the end portion of one of the spacers attached to the pad of the first pads being opposite to the first pads, the end portion of another of the spacers attached to the pad of the second pads being opposite to the second pads.

8. The substrate module according to claim 7, wherein the spacer is formed by stacking a metal layer.

9. The substrate module according to any one of claims 1 to 8, wherein:

   the first substrate is a wiring substrate including an antenna; and
   the second substrate is a semiconductor chip for controlling the antenna.

10. A method for producing a substrate module, the method comprising:

   preparing a first substrate including a plurality of first pads and a second substrate including a plurality of second pads; and
   electrically connecting the first substrate and the second substrate, wherein
   a spacer is attached to a pad of at least either of the first pads and the second pads, and
   one or more pairs of the first pads and the second pads not sandwiching the spacer are bonded with conductive paste in a state where the spacer is sandwiched between another pair of the first pads and the second pads.

FIG. 1A

FIG. 1B

FIG. 1C
(FIRST
EMBODIMENT)

FIG. 2A
(NORMAL CASE)

FIG. 2B
(ABNORMAL CASE)

FIG. 2C
(COMPARATIVE EXAMPLE)

FIG. 3A

12(10)  20  11(10)

41,41

B  B

12A(10)

41,41

FIG. 3B

21

21  20  21

41  41

10

13  31  13  11  13

FIG. 3C
(SECOND
EMBODIMENT)

1

21

21  20  21

41  41

10

13  31  13  11  13

FIG. 4A

FIG. 4B

FIG. 4C
(THIRD
EMBODIMENT)

FIG. 5A

21

20

31  13  11

10

FIG. 5B
(COMPARATIVE
EXAMPLE)

1

21

20

31  13  11

10

## INTERNATIONAL SEARCH REPORT

International application No.

PCT/JP2018/006160

### A. CLASSIFICATION OF SUBJECT MATTER
Int. Cl. H01L21/60(2006.01)i, H01L23/12(2006.01)i, H05K3/32(2006.01)i

According to International Patent Classification (IPC) or to both national classification and IPC

### B. FIELDS SEARCHED

Minimum documentation searched (classification system followed by classification symbols)
Int. Cl. H01L21/60, H01L23/12, H05K3/32

Documentation searched other than minimum documentation to the extent that such documents are included in the fields searched
Published examined utility model applications of Japan    1922-1996
Published unexamined utility model applications of Japan  1971-2018
Registered utility model specifications of Japan          1996-2018
Published registered utility model applications of Japan  1994-2018

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2001-15552 A (SHINKAWA LTD.) 19 January 2001,<br>paragraphs [0006]-[0010], fig. 1-3 (Family: none) | 1, 2, 4, 10<br>3, 5, 6, 9<br>7, 8 |
| Y<br>A | JP 2008-112810 A (KYOCERA CORP.) 15 May 2008,<br>paragraphs [0053]-[0058], fig. 10, 11 (Family:<br>none) | 3<br>7, 8 |
| Y<br>A | JP 2014-150102 A (SHINKO ELECTRIC INDUSTRIES CO.,<br>LTD.) 21 August 2014, paragraphs [0017]-[0019],<br>[0022] & US 2014/0210082 A1, paragraphs [0032]-<br>[0034], [0037] | 5, 6, 9<br>7, 8 |

☐ Further documents are listed in the continuation of Box C.  ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>18.04.2018 | Date of mailing of the international search report<br>01.05.2018 |
|---|---|
| Name and mailing address of the ISA/<br>    Japan Patent Office<br>    3-4-3, Kasumigaseki, Chiyoda-ku,<br>    Tokyo 100-8915, Japan | Authorized officer<br><br>Telephone No. |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014150102 A